Europäisches Patentamt

European Patent Office

Office européen des brevets

(19)

(11) Numéro de publication : **0 148 674**
**B1**

(12) **FASCICULE DE BREVET EUROPÉEN**

(45) Date de publication du fascicule du brevet :
**10.02.88**

(51) Int. Cl.⁴ : **G 01 R 31/11**

(21) Numéro de dépôt : **84402534.6**

(22) Date de dépôt : **10.12.84**

(54) **Dispositif et procédé de localisation de défauts de câbles.**

(30) Priorité : **10.01.84 FR 8400271**

(43) Date de publication de la demande :
**17.07.85 Bulletin 85/29**

(45) Mention de la délivrance du brevet :
**10.02.88 Bulletin 88/06**

(84) Etats contractants désignés :
**AT BE DE FR GB IT**

(56) Documents cités :
**EP-A- 0 072 882**
**ELEKTROTECHNISCHE ZEITSCHRIFT, E.T.Z., vol.**
**103, no. 4, février 1982, pages 177-180 , Berlin, DE; W.**
**RIETZ: "Fehlerortung bei Energiekabeln mit der**
**Lichtbogen-Stossmethode"**

(73) Titulaire : **BALTEAU S.A.**
**rue de Magnée, 54**
**B-4610 Beyne-Heusay (BE)**

(72) Inventeur : **Lefevre, Alain**
**48, rue Justin Lenders**
**B-4020 Liege (BE)**
Inventeur : **Rondeux, Christian**
**57, rue Dieudonné Salme**
**B-4000 Liege (BE)**

(74) Mandataire : **Bentz, Jean-Paul**
**GIERS SCHLUMBERGER Service BREVETS 12, place**
**des Etats-Unis**
**F-92124 Montrouge Cedex (FR)**

## Description

La présente invention concerne notamment un dispositif de localisation de défauts de câbles, comprenant un générateur d'ondes de choc propre à mettre le câble dans un état excité par la création d'un arc électrique transitoire à l'endroit du défaut, des moyens de synchronisation, et un réflectomètre relié au câble et comportant lui-même un générateur d'impulsions brèves de réflectométrie, propre à émettre sur le câble des impulsions susceptibles d'être réfléchies à l'endroit du défaut ou à l'autre extrémité du câble selon que le câble est à l'état excité ou non, et un organe d'affichage destiné à visualiser simultanément, en vue de permettre leur comparaison, les réflectogrammes des impulsions brèves progressant sur le câble à l'état excité d'une part et au repos d'autre part.

On appelle réflectogramme la courbe, en fonction du temps de la tension apparaissant sur le câble du fait des impulsions brèves qui, ayant été émises par le générateur, se réfléchissent soit sur l'arc électrique créé à l'endroit du défaut lorsque le câble est à l'état excité, soit à l'extrémité du câble qui est opposée à celle où est placé le générateur d'impulsions brèves lorsque le câble est au repos ; l'intégrale délimitée par cette courbe est associée à l'énergie des impulsions réfléchies.

D'autre part, on appelle réflectomètre ou écho-mètre tout instrument capable de produire et restituer, par exemple par visualisation sur un écran ou enregistrement dans une mémoire, un réflectogramme.

Les dispositifs de localisation de défauts de câble sont connus depuis de nombreuses années et sont notamment utilisés pour la localisation de défauts des câbles souterrains, de manière à permettre la réparation rapide de ces câbles dans de bonnes conditions grâce à une localisation rapide et précise du défaut.

Selon des procédés connus applicables aux câbles non combustibles, les impulsions brèves de réflectométrie sont envoyées en permanence sur le câble et les ondes de choc sont envoyées en rafales de manière que le câble se présente pour les impulsions de réflectométrie, sur un intervalle de temps assez long, alternativement à l'état de repos et à l'état excité.

Cette disposition permet, en utilisant un réflectomètre à écran cathodique, et avec une cadence appropriée des ondes de choc, de visualiser les réflectogrammes des impulsions brèves progressant sur le câble de façon simultanée pour les deux états du câble, en tirant parti de la rémanence de l'écran cathodique (voir par exemple elektronische Zeitschrift vol. 103, n° 4, février 1982, pages 177-180).

Néanmoins ces procédés connus ne sont pas dépourvus d'inconvénients notamment si on les transpose à la localisation de défauts sur des câbles combustibles.

En effet dans la pratique, la localisation finale du défaut est effectuée en envoyant une onde de choc sur le câble en défaut et en repérant, au moyen de détecteurs acoustiques, l'origine du bruit que provoque l'arc électrique dans le défaut ; or, des rafales d'ondes de choc injectées sur un câble en défaut ont toutes chances d'aggraver le défaut au point qu'une localisation ultérieure du défaut par voie acoustique ne puisse plus être faite dans des conditions favorables.

Dans ce contexte, le but de la présente invention est de proposer un dispositif et un procédé de localisation de défauts de câbles permettant la localisation du défaut par production d'une seule onde de choc, de manière à ne pas dégrader sensiblement l'état de conduction du câble.

Le dispositif conforme à l'invention est essentiellement caractérisé en ce que le réflectomètre utilisé comprend, une mémoire à accès rapide permettant la sauvegarde d'un réflectogramme en une seule acquisition, et en ce que lesdits moyens de synchronisation permettant de coordonner dans le temps l'émission d'une onde de choc et l'accès à la mémoire du réflectomètre pour l'enregistrement dans cette mémoire du réflectogramme caractéristique du câble à l'état excité en ne produisant qu'une seule onde de choc.

Il serait possible, pour la mise en œuvre du procédé de l'invention, d'utiliser un réflectomètre capable d'enregistrer seulement le réflectogramme caractéristique du câble à l'état excité.

Ce réflectogramme enregistré du câble excité pourrait être appelé sur l'écran cathodique au moment où une mesure de réflectométrie du câble au repos serait effectuée, de manière que les réflectogrammes du câble excité et au repos soient simultanément visibles à l'écran.

Néanmoins, il est plus aisé d'utiliser un réflectomètre doté d'une mémoire à au moins deux canaux, de façon à pouvoir enregistrer à la fois le réflectogramme du câble excité et celui du câble au repos.

Les réflectomètres à mémoire comportent une synchronisation interne coordonnant dans le temps l'émission d'une impulsion brève de réflectométrie et l'accès à la mémoire pour le réflectogramme. Ces réflectomètres sont généralement capables de produire des impulsions de réflectométrie isolées (one shot) ou répétées. Dans ce dernier cas le dernier réflectogramme reçu remplace en mémoire un réflectogramme reçu antérieurement.

Le générateur d'ondes de choc comprend par exemple un générateur haute tension branché aux bornes d'un condensateur de stockage d'énergie et le dispositif comporte un commutateur haute tension susceptible d'être commandé par les moyens de synchronisation pour isoler l'un de l'autre le condensateur et le câble pendant la charge du condensateur et mettre en contact le condensateur et le câble pour produire une onde de choc dans ce dernier.

De préférence, les moyens de synchronisation comprennent un détecteur recevant l'onde de choc sensiblement en même temps que le câble et produisant un signal de détection au moment où le signal qu'il reçoit dépasse un seuil prédéterminé.

En outre, les moyens de synchronisation comprennent avantageusement une cellule à retard fonctionnellement reliée au détecteur et au réflectomètre et n'autorisant l'accès à la mémoire de celui-ci qu'après un certain intervalle de temps après l'apparition du signal de détection, de façon à assurer que le réflectogramme du câble excité sera produit après stabilisation de l'onde de choc.

Un circuit de temporisation d'accès mémoire déclenché par la cellule à retard et fonctionnellement relié au réflectomètre peut être prévu pour n'autoriser l'accès à la mémoire de celui-ci que pendant un intervalle de temps déterminé à compter du déclenchement de ce circuit de temporisation.

Un organe de commande manuelle peut être prévu pour commander les moyens de synchronisation, qui peuvent comprendre en outre un circuit de temporisation de charge fonctionnellement dépendant de cet organe de commande manuelle et agissant lui-même sur le générateur haute tension pour faire charger le condensateur par ce générateur pendant un intervalle de temps déterminé ainsi qu'un circuit de temporisation de décharge déclenché par le circuit de temporisation de charge pour fermer le commutateur haute tension et permettre ainsi la décharge du condensateur pendant un intervalle de temps déterminé.

Le procédé de l'invention, comprenant les étapes consistant à exciter le câble en émettant une onde de choc propre à créer un arc électrique à l'endroit du défaut, à émettre des impulsions de réflectométrie sur le câble, et à recevoir les impulsions réfléchies, est donc essentiellement caractérisé en ce qu'on produit une seule onde de choc à un instant déterminé, et en ce qu'on enregistre les impulsions réfléchies au bout d'un intervalle de temps déterminé à compter de la production de l'onde de choc.

En outre, on enregistre les impulsions réfléchies pendant un intervalle de temps déterminé et l'on définit l'instant de production de l'onde de choc en détectant l'instant où l'amplitude de l'onde de choc appliquée au câble dépasse un seuil prédéterminé.

D'autres caractéristiques et avantages de l'invention ressortiront de la description qui en est faite ci-après, à titre indicatif et nullement limitatif, en référence au dessin annexé dans lequel :

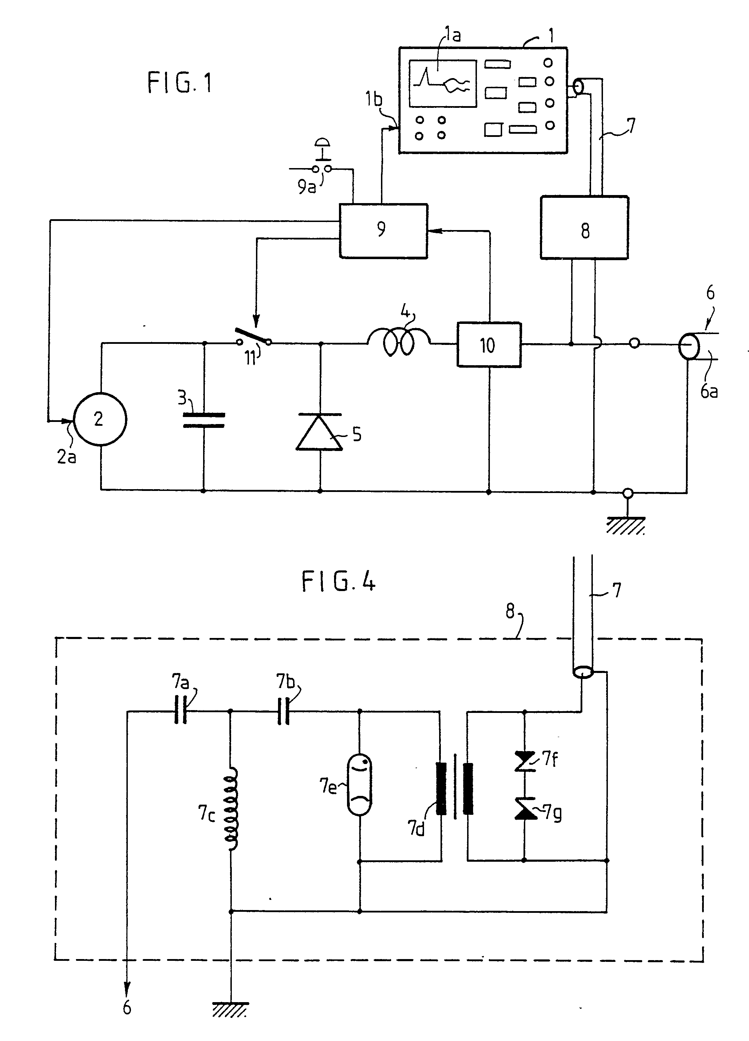

la figure 1 est un schéma général du dispositif de l'invention,

la figure 2 représente le circuit de synchronisation,

la figure 3 représente le détecteur de l'onde de choc, et

la figure 4 représente un filtre d'énergie connu en soi.

Le dispositif de l'invention comprend un réflectomètre 1 à mémoire à accès rapide, susceptible d'enregistrer deux réflectogrammes par une acquisition directe pour chacun d'eux.

Ce réflectomètre comporte un organe d'affichage tel qu'un écran cathodique 1a, ainsi qu'un générateur interne d'impulsions de réflectométrie et une mémoire interne (non représentés, mais reliés au câble coaxial 7). Les impulsions de réflectométrie sont, de façon classique, des impulsions brèves (de l'ordre de 100 ns) à basse tension (de 25 à 80 V par exemple).

Le dispositif comprend également un générateur d'ondes de choc, connu en soi, composé lui-même essentiellement d'un générateur haute tension 2, d'un condensateur de stockage 3, d'une inductance 4 et d'une diode de récupération (ou de « roue libre ») 5.

Le générateur haute tension 2 est essentiellement constitué d'un transformateur et d'un redresseur haute tension et comporte une entrée de commande 2a par laquelle son fonctionnement peut être commandé.

Le condensateur 3, l'inductance 4 et la diode 5 forment un système de stockage d'énergie électrique à relaxation, connu en soi, propre à délivrer, après que le condensateur 3 ait été chargé par le générateur 2, une onde de choc à décroissance relativement lente pendant un intervalle de temps relativement long. L'ensemble est relié au câble en défaut 6 dont la gaine externe 6a est reliée à la terre, ainsi que la borne négative du générateur 2.

Le réflectomètre 1 est relié au câble en défaut 6 par l'intermédiaire d'un câble coaxial 7 et d'un filtre d'énergie 8.

Un tel filtre d'énergie, connu en soi, est représenté à la figure 4. La fonction de ce filtre est d'assurer le blocage vers le réflectomètre de l'onde de choc à basse fréquence appliquée au câble 6, tout en transmettant du réflectomètre vers le câble 6, ou plus précisément du générateur d'impulsions brèves vers le câble, les impulsions de réflectométrie émises, et du câble vers le réflectomètre, ou plus précisément du câble vers la mémoire interne du réflectomètre, les impulsions de réflectométrie réfléchies par le câble.

Ce filtre d'énergie comprend essentiellement par exemple un diviseur capacitif 7a, 7b associé à une inductance 7c pour assurer la fonction de filtrage, un transformateur 7d pour assurer le couplage réflectomètre-filtre, et des éléments de protection de ce transformateur, tels qu'un éclateur 7c du côté du câble en défaut 6 et des diodes Zener 7f, 7g du côté du réflectomètre.

A l'intérieur du réflectomètre 1, et de façon connue en soi, le câble coaxial 7 est relié d'une part au générateur d'impulsions de réflectométrie et d'autre part à la mémoire capable de sauvegarder les réflectogrammes.

Outre les éléments déjà décrits, le dispositif comprend un circuit de synchronisation 9, un détecteur d'onde de choc 10 et un commutateur haute tension 11.

Le commutateur 11 est disposé entre le condensateur 3 et le câble en défaut. Ce commutateur est commandé par le circuit de synchronisation 9.

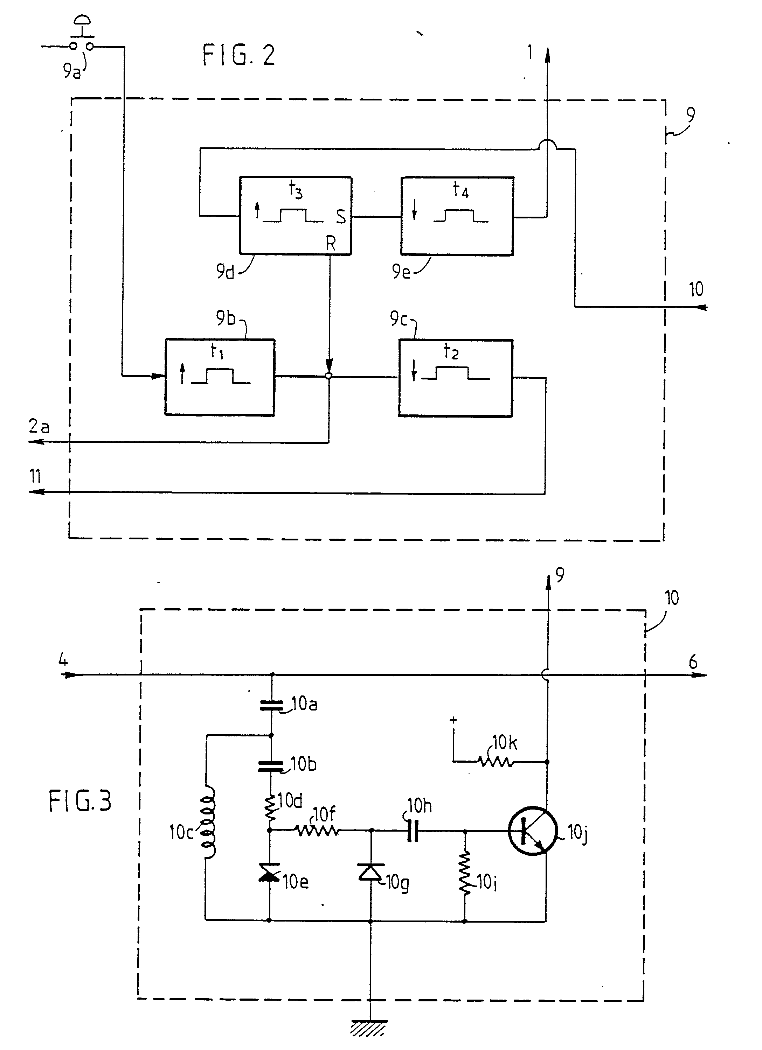

Ce circuit de synchronisation est décrit en plus grand détail sur la figure 2.

Un organe de commande manuelle tel qu'un bout-pressoir 9a est prévu pour déclencher l'ensemble.

Cet organe agit sur un circuit de temporisation de charge 9b, constitué par exemple par une bascule monostable, dont la sortie, reliée à l'entrée 2a du générateur haute tension, commande le fonctionnement de ce générateur pendant un intervalle de temps t1, en vue de charger le condensateur 3 ; pendant l'intervalle de temps t1, l'interrupteur 11 est ouvert.

Le circuit de temporisation de charge 9b est, par sa sortie, relié à un circuit de temporisation de décharge 9c qu'il commande à la fin de l'intervalle t1 ; le circuit 9c commande alors à son tour la fermeture du commutateur 11 pendant un intervalle de temps t2, dès le début de l'intervalle t2, une onde de choc est donc appliquée au câble en défaut 6. En outre, dès le début de l'intervalle de temps t2, le générateur haute tension est inhibé par la retombée du signal du circuit de temporisation de charge 9b.

Dès que son amplitude a atteint un seuil déterminé, l'onde de choc est détectée par le détecteur 10 qui fournit un signal de détection à une cellule à retard 9d du circuit de synchronisation. Cette cellule délivre, à un autre circuit de temporisation 9e relié à sa sortie S, un signal de validation apparaissant au bout d'un temps t3 à compter du début du signal de détection issu du détecteur 10. La cellule à retard 9d qui, comme les circuits de temporisation, peut être constituée d'une bascule monostable, peut délivrer sur une sortie R un signal de remise à zéro transmis à l'entrée 2a du générateur 2 en vue d'autoriser une commande ultérieure de ce générateur.

Le circuit de temporisation 9e délivre à sa sortie reliée à une entrée de commande 1b du réflectomètre, pendant un intervalle de temps t4, un signal d'autorisation d'accès à la mémoire interne du réflectomètre pour un réflectogramme en provenance du câble en défaut 6.

La raison d'être et le rôle fonctionnel de ce signal d'autorisation d'accès sont les suivants :

Au moment où le commutateur 11 est fermé, l'onde de choc présente un régime transitoire très instable riche en composantes à fréquence élevée ; aucune mesure de réflectométrie ne peut donc être effectuée pendant une certaine période, que la cellule 9d fixe égale à t3.

Dès que cette période d'instabilité est passée, le réflectomètre peut être déclenché et c'est le rôle du signal produit par le circuit de temporisation 9e de permettre ce déclenchement.

Néanmoins, les réflectomètres à mémoire sont conçus avec une synchronisation interne du générateur d'impulsions de réflectométrie et de l'accès à la mémoire des réflectogrammes, et émettent généralement des impulsions brèves en série avant même de recevoir, et éventuellement après avoir reçu, l'ordre d'enregistrer dans la mémoire les impulsions réfléchies.

Le rôle précis du signal d'autorisation d'accès fourni par le circuit de temporisation 9e n'est donc pas dans ce cas de déclencher positivement l'accès à la mémoire indépendamment de l'instant de production d'une impulsion de réflectométrie, mais de valider, lorsque ce signal est présent, et d'interdire lorsqu'il est absent, le déclenchement de la mémoire interne du réflectomètre par le circuit de synchronisation interne de ce dernier. Il est capital en effet que la mémoire du réflectomètre, généralement susceptible d'enregistrer des phénomènes de quelques dizaines à quelques centaines seulement de millisecondes, reste contrôlée dans le temps en fonction de l'émission d'une impulsion de réflectométrie.

A la fin de l'intervalle de temps t4, qui correspond à l'instant de retour d'impulsions de réflectométrie réfléchies par un arc électrique sur le point de s'éteindre, l'accès à la mémoire est inhibé par la retombée du signal du circuit de temporisation 9e.

La fréquence d'émission des impulsions de réflectométrie est réglée en fonction du dimensionnement des composants 3 à 5 du générateur d'ondes de choc, ou inversement, pour assurer qu'une impulsion de réflectométrie sera produite et réfléchie sur l'arc pendant le temps t4, au plus égal au temps de production d'une onde de choc, diminué du temps t3.

L'enregistrement du réflectogramme caractéristique du câble au repos est effectué de façon classique au moyen du réflectomètre 1, éventuellement à travers le filtre 8.

Bien que les intervalles de temps t1 à t4 aient été représentés comme fixes, il est possible de les prévoir réglables. A ce titre, l'expression « intervalle de temps déterminé » ne sera pas considérée comme excluant un intervalle de temps réglable.

La figure 3 représente le détail d'un mode de réalisation possible d'un détecteur 10. Tout détecteur de dépassement de seuil, de tension ou de courant, peut être utilisé pour constituer le détecteur 10.

Le détecteur particulier représenté fonctionne suivant le principe d'un dépassement de seuil de tension et comprend : un diviseur capacitif 10a, 10b associé à une inductance 10c ; un écrêteur comprenant la résistance 10d, la diode Zener 10e, la résistance 10f, et la diode 10g ; et le détecteur de seuil proprement dit, constitué par le condensateur 10h, la résistance 10i, le transistor 10j, et la résistance 10k.

## Revendications

1. Dispositif de localisation de défauts de câbles, comprenant un générateur d'ondes de choc (2, 3, 4, 5, 11) propre à mettre le câble dans un état excité par la création d'un arc électrique transitoire à l'endroit du défaut, des moyens de synchronisation (9) et un réflectomètre (1) relié au câble et comportant lui-même un générateur d'impulsions brèves propre à émettre sur le câble des impulsions susceptibles d'être réfléchies à l'endroit du défaut ou à l'autre extrémité du câble selon que le câble est à l'état excité ou non, ainsi qu'un organe d'affichage (1a) destiné à visualiser simultanément, en vue de permettre leur comparaison, les réflectogrammes des impulsions brèves progressant sur le câble à l'état excité d'une part et au repos d'autre part, caractérisé en ce que le réflectomètre comprend une mémoire à accès rapide permettant la sauvegarde d'un réflectogramme en une seule acquisition, et en ce que lesdits moyens de synchronisation permettent de coordonner dans le temps l'émission d'une onde de choc et l'accès à la mémoire du réflectomètre de manière à permettre l'enregistrement, dans cette mémoire, du réflectogramme caractéristique du câble excité en ne produisant qu'une seule onde de choc.

2. Dispositif selon la revendication 1, dans lequel le générateur d'ondes de choc comprend un générateur haute tension (2) branché aux bornes d'un condensateur (3) de stockage d'énergie, caractérisé en ce qu'il comporte en outre un commutateur (11) haute tension susceptible d'être commandé par les moyens de synchronisation pour isoler l'un de l'autre le condensateur et le câble pendant la charge du condensateur et mettre en contact le condensateur chargé et le câble pour produire une onde de choc dans ce dernier.

3. Dispositif selon la revendication 2, caractérisé en ce que les moyens de synchronisation comprennent un détecteur (10) recevant l'onde de choc sensiblement en même temps que le câble et produisant un signal de détection au moment où le signal qu'il reçoit dépasse un seuil prédétermimé.

4. Dispositif selon la revendication 3, caractérisé en ce que les moyens de synchronisation comprennent une cellule à retard (9d) fonctionnellement reliée au détecteur et au réflectomètre et n'autorisant l'accès à la mémoire de celui-ci qu'après un certain intervalle de temps après l'apparition du signal de détection, de façon à assurer que le réflectogramme du câble excité sera produit après stabilisation de l'onde de choc.

5. Dispositif suivant la revendication 4, caractérisé en ce que les moyens de synchronisation comprennent un circuit de temporisation (9e) d'accès mémoire déclenché par la cellule à retard et fonctionnellement relié au réflectomètre pour n'autoriser l'accès à la mémoire de celui-ci que pendant un intervalle de temps déterminé à compter du déclenchement de ce circuit de temporisation.

6. Dispositif suivant l'une quelconque des revendications 2 à 4, caractérisé en ce que les moyens de synchronisation comprennent un organe de commande manuelle (9a) ainsi qu'un circuit de temporisation de charge (9b) fonctionnellement dépendant de cet organe de commande manuelle et agissant lui-même sur le générateur haute tension pour faire charger le condensateur par ce générateur pendant un intervalle de temps déterminé.

7. Dispositif selon la revendication 6, caractérisé en ce que les moyens de synchronisation comprennent un circuit de temporisation de décharge (9c) déclenché par le circuit de temporisation de charge pour fermer le commutateur haute tension et permettre ainsi la décharge du condensateur pendant un intervalle de temps déterminé.

8. Procédé de localisation de défauts de câbles, comprenant les étapes consistant à exciter le câble en émettant une onde de choc propre à créer un arc électrique à l'endroit du défaut, à émettre des impulsions de réflectométrie sur le câble, et à recevoir les impulsions réfléchies, caractérisé en ce qu'on produit une seule onde de choc à un instant déterminé, et en ce qu'on enregistre les impulsions réfléchies au bout d'un intervalle de temps déterminé à compter de la production de l'onde de choc.

9. Procédé selon la revendication 8, caractérisé en ce qu'on enregistre les impulsions réfléchies pendant un intervalle de temps déterminé.

10. Procédé selon l'une quelconque des revendications 8 et 9, caractérisé en ce qu'on détermine l'instant de production de l'onde de choc en détectant l'instant où l'amplitude de l'onde de choc appliquée au câble, dépasse un seuil prédéterminé.

**Claims**

1. A device for locating cable faults, comprising a shock-wave generator (2, 3, 4, 5, 11) for setting the cable into an excited state by creating a transient electric arc at the fault location, synchronizing means (9) and a reflectometer (1) coupled to the cable and including a short-pulse generator for transmitting on the cable pulses to be reflected at the fault location or at the other end of the cable, according to wether the cable is in the excited state or not, as well as a display unit (1a) for simultaneously displaying the reflectograms of pulses propagating on the cable in the excited state, on the one hand, and at rest, on the other hand, for comparing the same, characterized in that the reflectometer comprises a fast access memory for saving a reflectogram in a single acquisition step, and that the synchronizing means are intended to coordinate in time the transmission of a shock wave and access to the reflectometer memory so as to allow recording, into such memory, of the reflectogram which characterizes the excited cable while producing only one shock wave.

2. A device according to claim 1, wherein the shock-wave generator comprises a high-voltage generator (2) connected across an energy-storing capacitor (3), characterized in that it further comprises a high-voltage switch (11) to be controlled by the synchronizing means, for isolating the capacitor and the cable from one another during capacitor charging, and contacting the charged capacitor and the cable for generating a shock wave within the latter.

3. A device according to claim 2, wherein the synchronizing means comprise a detector (10) for receiving the shock wave at substantially the same time as the cable, and generating a detection signal at the time the signal it receives has exceeded a predetermined threshold.

4. A device according to claim 3, characterized in that the synchronizing means comprise a delay unit (9d) operatively connected to the detector and to the reflectometer, and allowing access to its memory only when a given time has elapsed after the occurrence of the detection signal, so as to make sure that the reflectogram of the excited cable is generated after the shock wave has stabilized.

5. A device according to claim 4, characterized in that the synchronizing means comprise a memory access timing circuit (9e) triggered by the delay unit and operatively connected to the reflectometer, so as to allow access to the memory thereof only during a given time period starting from the triggering of said timing circuit.

6. A device according to any of claims 2 to 4, characterized in that the synchronizing means comprise a manual control member (9a) and a charge timing circuit (9h) operatively controlled by said manual control member, and itself acting upon the high-voltage generator to cause the capacitor to be charged by said generator during a given time period.

7. A device according to claim 6, characterized in that the synchronizing means comprise a discharge timing circuit (9c) triggered by the charge timing circuit for closing the high-voltage switch and thus allowing the capacitor to discharge during the given time period.

8. A method for locating cable faults, comprising the steps of exciting a cable by transmitting a shock wave able to create an electric arc at the fault location, transmitting reflectometry pulses on the cable, and receiving the reflected pulses, characterized in that only one shock wave is generated at a given time, and that the reflected pulses are recorded after a given time period starting from the shak wave generation.

9. A method according to claim 8, characterized in that the reflected pulses are recorded during a given time period.

10. A method according to any of claims 8 and 9, characterized in that the time of shock wave generation is determined by detecting the time when the amplitude of the shock wave applied to the cable exceeds a given threshold.

## Patentansprüche

1. Vorrichtung zum Auffinden von Kabelfehlern mit einem Schockwellengenerator (2, 3, 4, 5, 11), der das Kabel durch Erzeugen eines Lichtbogens an der defekten Stelle vorübergehend in einen angeregten Zustand versetzen kann, Synchronisierungsmitteln und einem Reflektometer (1), das mit dem Kabel verbunden ist und seinerseits einen Generator zur Erzeugung kurzer Impulse enthält, der auf das Kabel Impulse emittieren kann, die geeignet sind, an der Defektstelle oder am anderen Kabelende reflektiert zu werden, je nachdem, ob das Kabel im angeregten oder im nicht angeregten Zustand ist, weiterhin mit einem Anzeigegerät (1a), das dazu dient, die Reflektogramme der im Kabel fortschreitenden kurzen Impulse, das sich einerseits im angeregten und andererseits im Ruhezustand befindet, gleichzeitig anzuzeigen, damit sie verglichen werden können, dadurch gekennzeichnet, daß das Reflektometer einen Speicher mit schnellem Zugriff enthält, der das Speichern eines Reflektogramms in einer einzigen Aufnahme ermöglicht, und daß die Synchronisierungsmittel die Emission einer Schockwelle und den Zugriff zum Speicher des Reflektometers zeitlich so koordinieren können, daß die Aufnahme des charakteristischen Reflektogramms des angeregten Kabels in diesen Speicher durch Erzeugung nur einer einzigen Schockwelle erreicht werden kann.

2. Vorrichtung nach Anspruch 1, in der der Schockwellengenerator einen an die Anschlüsse eines Kondensators (3) zur Energiespeicherung angeschlossenen Hochspannungsgenerator (2) enthält, dadurch gekennzeichnet, daß sie weiterhin einen Hochspannungsschalter (11) enthält, der geeignet ist, von den Synchronisierungsmitteln betätigt zu werden, um den Kondensator und das Kabel während des Aufladens des Kondensators voneinander zu trennen und den geladenen Kondensator und das Kabel in Kontakt zueinander zu bringen, um eine Schockwelle im letzteren zu erzeugen.

3. Vorrichtung nach Anspruch 2, dadurch gekennzeichnet, daß die Synchronisierungsmittel einen Detektor (10) enthalten, der die Schockwelle im wesentlichen zur gleichen Zeit wie das Kabel empfängt und ein Erfassungssignal erzeugt, sobald das Signal, das er empfängt, eine vorbestimmte Schwelle überschreitet.

4. Vorrichtung nach Anspruch 3, dadurch gekennzeichnet, daß die Synchronisierungsmittel eine Verzögerungszelle (9d) enthalten, die mit dem Detektor und dem Reflektometer funktionell verbunden ist und den Zugriff zum Speicher des Reflektometers erst nach einem gewissen Zeitintervall nach Auftreten des Erfassungssignals ermöglicht, um sicherzustellen, daß das Reflektogramm des angeregten Kabels nach Stabilisierung der Schockwelle erzeugt wird.

5. Vorrichtung nach Anspruch 4, dadurch gekennzeichnet, daß die Synchronisierungsmittel einen Speicherzugriffszeitsteuerschaltkreis (9e) enthalten, der von der Verzögerungszelle getriggert wird und mit dem Reflektometer funktionell verbunden ist, um den Zugriff zu dessen Speicher nur während eines bestimmten Zeitintervalls zu erlauben, das mit dem Triggern dieses Verzögerungsschaltkreises beginnt.

6. Vorrichtung nach einem der Ansprüche 2 bis 4, dadurch gekennzeichnet, daß die Synchronisierungsmittel ein Organ zur manuellen Bedienung (9a) sowie einen Ladungszeitsteuerschaltkreis (9b) enthalten, der vom Organ zur manuellen Bedienung funktionell abhängt und seinerseits auf den Hochspannungsgenerator wirkt, um den Kondensator durch den Generator während eines bestimmten Zeitintervalls laden zu lassen.

7. Vorrichtung nach Anspruch 6, dadurch gekennzeichnet, daß die Synchronisierungsmittel einen Entladungszeitsteuerschaltkreis (9c) enthalten, der durch den Ladungszeitsteuerschaltkreis getriggert wird, um den Hochspannungsschalter zu schließen und dadurch die Entladung des Kondensators während eines bestimmten Zeitintervalls zu ermöglichen.

8. Verfahren zum Lokalisieren von Kabeldefekten, das folgende Schritte enthält : Anregen des Kabels durch Emittieren einer Schockwelle, die geeignet ist, einen Lichtbogen an der Defektstelle zu erzeugen, Emittieren von Reflektrometrieimpulsen auf das Kabel, und Empfangen der reflektierten Impulse, dadurch gekennzeichnet, daß zu einem bestimmten Zeitpunkt eine einzige Schockwelle erzeugt wird, und daß die reflektierten Impulse am Ende eines Zeitintervalls aufgezeichnet werden, das von der Erzeugung der Schockwelle ab gemessen wird.

9. Verfahren nach Anspruch 8, dadurch gekennzeichnet, daß die während eines bestimmten Zeitintervalls reflektierten Impulse aufgezeichnet werden.

10. Verfahren nach einem der Ansprüche 8 und 9, dadurch gekennzeichnet, daß der Zeitpunkt der Schockwellenerzeugung bestimmt wird, indem der Zeitpunkt festgestellt wird, in dem die Amplitude der auf das Kabel angewandten Schockwelle eine vorbestimmte Schwelle überschreitet.

FIG.1

FIG.4

FIG. 2

FIG. 3